# EUROPEAN PATENT APPLICATION

(11) **EP 2 199 426 A1**
(43) Date of publication of application: **23.06.2010**
(21) Application number: 08172414.8
(22) Date of filing: 19.12.2008
(51) Int. Cl.: C23C 14/24, C23C 14/12

(54) **Evaporation source with exchangeable nozzles**

(30) Priority: 18.12.2008 EP 08022008
(71) Applicant: Applied Materials, Inc., Santa Clara, CA 95054 (US)
(72) Inventor: Bangert, Stefan, 36396 Steinau (DE); Mattern, Frank, 63452 Hanau (DE); Ries, Florian, 63825 Westerngrund (DE); Sommer, Elisabeth, 63755 Alzenau (DE); Roth, Jürgen, 63477 Maintal (DE)
(74) Representative: Lang, Christian

(57) **Abstract**

The invention refers to an evaporation source for depositing of thin layers on substrates, the evaporation source comprising a vapor distribution system having an evaporation pipe (6) made of inorganic non metallic material, with the evaporation pipe having at least one nozzle, wherein the nozzle is disposed in a nozzle element (11, 12, 13) which is made as a separate component being arranged in a nozzle element opening (16, 21, 22) of the evaporation pipe.

## Description

### BACKGROUND OF THE INVENTION

### FIELD OF THE INVENTION

The present invention refers to an evaporation source for deposition of thin layers on substrates wherein the evaporation source comprises a vapour distribution system having an evaporation pipe made of inorganic non-metallic material which comprises at least one nozzle. Moreover, the present invention also refers to a method of producing an organic light emitting diode stack by using the before-mentioned evaporation source.

### PRIOR ART

Evaporation sources for thermally evaporating material to be deposited on substrates as a thin film are known from prior art, for example from the European patent application EP 1 672 715 A1. It is also known to use such evaporation sources for producing layer stacks of organic light emitting diode structures in order to produce displays, monitors or the like.

For the production of OLED (organic light emitting diode) structures it is important to obtain thin layers having a good homogeneity. Especially with respect to large-scale substrates, as for example large-scale glass plates to be used for large television screens or the like, the requirements for the evaporation sources to be able to supply the evaporated material in a defined manner are increasing.

Evaporation sources, like the evaporation source described in EP 1672715 A1, use a vapour distribution system comprising quartz glass pipes. Especially the evaporation pipe which contains the evaporation nozzles, where the vaporized material is released, are made of quartz glass tubes.

The nozzles are cut into the quartz glass material of the evaporation pipe by laser cutting, so that a plurality of small nozzle openings can easily be achieved. However, due to melting processes during the cutting of the nozzles into the quartz glass material by laser and resolidification of the melted material the nozzles produced in this way may not show the predetermined form and dimensions of the desired nozzle openings. This results in deviations from the calculated deposition profile and may therefore have a negative influence on the homogeneity of the deposited thin film.

### DISCLOSURE OF THE INVENTION

### OBJECT OF THE INVENTION

It is therefore an object of the invention to provide an evaporation source which allows for homogeneous deposition of thin film, especially thin films which are needed for the production of OLED structures. Moreover, the evaporation source should easily be manufactured and should allow operation in an economic way without overwhelming effort.

### TECHNICAL SOLUTION

The above-mentioned objects are achieved by an evaporation source having the features of claim 1. Moreover, a method is disclosed for producing OLED structures according to claim 15. Preferred embodiments are subject matter of the dependent claims.

According to the invention, an evaporation source is provided which comprises separate nozzle elements to be inserted into nozzle element openings of an inorganic non-metallic evaporation pipe of a vapour distribution system. For example, the evaporation source of EP 1 672 715 A1 is refined by replacing the laser cut nozzles by separate nozzle elements which are inserted into nozzle element openings of the quartz glass evaporation pipe. By doing this, it is possible to separately produce the nozzle elements, so that well defined nozzles or nozzle openings can be achieved by appropriate production methods. This leads to an improved homogeneity of the thin layer films deposited by the inventive evaporation source while the advantages of the quartz glass evaporation pipe may be maintained.

Moreover, due to the separate production of the nozzle elements, the nozzle elements may be accommodated in the evaporation pipe in a manner so that they are exchangeable. Therefore, the nozzles or nozzle elements can separately be exchanged so that in case of a defect nozzle not the whole evaporation pipe has to be exchanged, but only the defect nozzle element. This allows a very economic operation of the evaporation source.

Furthermore, in order to optimize the coating homogeneity, nozzles with different inner diameter and/or size can be easily used.

As already mentioned, the evaporation pipe as well as the nozzle elements can still be made of quartz glass, but also other materials are considerable.

For the production of the nozzle elements different production techniques may be used, which can be selected with a focus on the defined and exact production of the nozzle opening or the opening channel of the nozzle. Especially for quartz glass nozzle elements glass forming methods involved in producing very exact capillary tubes may be used.

In order to allow a defined placement of a nozzle element into the evaporation pipe, both the nozzle element as well as the nozzle element opening in the evaporation pipe may be grinded so as to have corresponding chuck cones at the inner surface of the nozzle element opening in the evaporation pipe and at the outer surface of the nozzle element. The corresponding chuck cones similar to the closing of glass bottles used for storing of chemicals allow for tight and precise positioning of the nozzle elements in the evaporation pipe by just inserting or plugging the nozzle element into the nozzle element opening of the evaporation pipe.

The nozzle element may be fixed in the nozzle element opening by clamping means, especially a metallic fixation ring or a bracket.

Due to the separate production of the nozzle elements, the length of the opening channel as well as the diameter of the opening channel can be chosen and exactly produced according to the specific requirements. Especially, it is possible to use nozzle elements being different with respect to the form and the dimensions of the opening channel through which the evaporated material is released towards the substrate. Only the region of the nozzle element being in contact with the nozzle element opening of the evaporation pipe is identical for all nozzle elements used in the evaporation pipe, in order to make change of the nozzle elements and insertion of the nozzle elements very easy.

Accordingly, the nozzle elements may have a length which is greater than the depth of the nozzle element opening so that the length of the opening channel of the nozzle element can be chosen according to the specific requirements. Especially for nozzle elements which are plugged into the evaporation pipe from the outside at least the cross sections in the region towards the nozzle outlet are identical in order to fit in the identical nozzle element openings.

The nozzle elements can be arranged in the evaporation pipe in different ways, for example in at least one line to provide a line source or in an array of columns and rows to define an evaporation field.

As mentioned before, the evaporation source of the present invention is especially suited for depositing of thin films necessary for producing an OLED structure, since the evaporation source allows for the homogeneous deposition of thin films on large-scale substrates.

### SHORT DESCRIPTION OF THE FIGURES

Further advantages, characteristics and features of the present invention become apparent by the following detailed description of a preferred embodiment of the present invention according to the attached drawings. The drawings show in a purely schematic form in
- Figure 1: a cross section through an inventive evaporation source;
- Figure 2: a partial sectional view through the evaporation pipe of the evaporation source of figure 1 as indicated by detail x; and in
- Figure 3: a partial cross section through the evaporation pipe of figures 1 and 2.

### EXAMPLE OF AN INVENTIVE EMBODIMENT

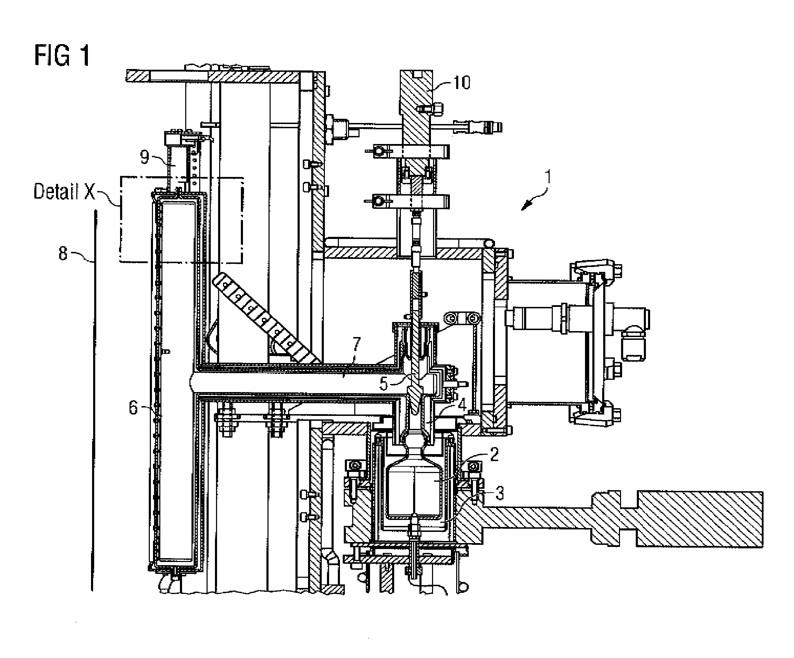

Figure 1 shows an evaporation source in accordance with the present invention which may be used for the deposition of thin films on a substrate 8. Especially, such an evaporation source which is similar to an evaporation source described in EP 1 672 715 A1 may be used for depositing thin layers in the process for production of organic light emitting diodes (OLED) or OLED structures, for example for OLED monitors or the like. Accordingly, EP1 672 715 A1 is completely incorporated herein by reference.

During the deposition the substrate 8, which may have the form of a plate, is passed in front of the evaporation source, so that the vaporized material to be deposited on the substrate 8 may reach the substrate surface and deposit thereon. Accordingly, an inline coating process, also called dynamic coating process, may be performed with the evaporation source shown in figure 1.

The material to be deposited on the substrate 8 is contained in a crucible 2 of the vaporizer in order to transfer the material into the gas state by heating. For this reason heating elements 3 like electric heating elements, resistance heating elements or the like are arranged near to the crucible 2 and near to all tubes (4,6,7), where the vapour is lead through, in order to prevent condensation.

The vaporized material leaves the crucible 2 through the manifold 4 which can be closed by a valve 5. The valve is driven by a valve-drive 10 arranged above the manifold 4.

The evaporation source 1 as shown in figure 1 comprises a vapour distribution system formed by two pipes or tubes 6 and 7 which are arranged to be in connection with the manifold 4 and the crucible 2.

The connecting pipe 7 is arranged transverse, especially perpendicular to the manifold 4 and the evaporation pipe 6 and is connected to both of them. Accordingly, vapour leaving the crucible 2 is lead by the connecting pipe 7 into the evaporation pipe 6.

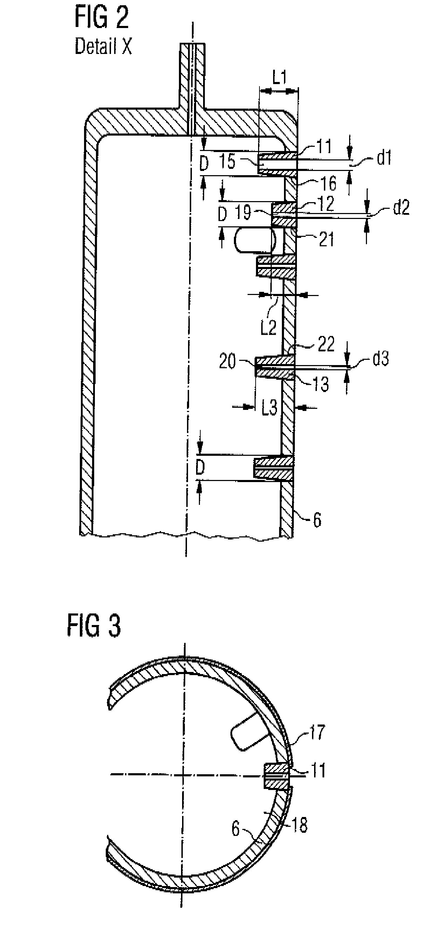

The evaporation pipe comprises at the side, which is facing the substrate 8, a plurality of nozzles, which are shown in detail in figure 2.

The connecting pipe 7 and the evaporation pipe 6 are both formed of quartz glass. In addition, different casings or shieldings and heater elements may be arranged around the quartz glass pipes, for example for thermal insulation and for heating of the tubes in order to prevent condensation of the vaporized material.

In figure 2, a partial cross section of the evaporation pipe 6 is shown. The evaporation pipe 6 comprises several nozzle elements 11 to 13 which are inserted into nozzle element openings, which are provided in the evaporation pipe 6.

As can be seen from figure 2, the nozzle elements 11 to 13 are different with respect to the form of the nozzle opening channels 15. While the diameter d1 of the opening channel 15 of the nozzle element 11 is relatively large, the diameter d3 of the nozzle element 13 is rather small. Accordingly, the diameter d1 of the opening channel 15 of the nozzle element 11 is bigger than the diameter d2 of the opening channel of the nozzle element 12 which is again bigger than the diameter d3 of the opening channel of the nozzle element 13.

Moreover, the nozzle elements 11, 12, 13 are also different with respect to the length of the opening channel. The length L3 of the opening channel 20 of the nozzle element 13 is bigger than the length L1 of the opening channel 15 of the nozzle element 11 which is again longer than the length L2 of the opening channel 19 of the nozzle element 12.

However, although the nozzle elements 11 to 13 being different with respect to the form and /or the dimensions of the opening channels 15, 19 and 20, the nozzle elements 11 to 13 are at least identical with respect to part of the outer dimensions and / or form. The nozzle element openings 16, 21 and 22 of the evaporation pipe 6, in which the nozzle elements 11 to 13 are accommodated, all have the same diameter D. Accordingly, at least part of the outer form of the nozzle elements 11 to 13 being arranged in the nozzle element openings 16, 21, 22 of the evaporation pipe 6 are identical to each other.

The nozzles 11 to 13 are formed as glass capillary tubes, the outer skirt of which is grinded to form a chuck cone. An identical chuck cone is grinded into the nozzle element openings 16, 21 and 22 of the evaporation pipe so that a tight glass connection can be achieved between the quartz glass nozzle elements 11 to 13 and the quartz glass evaporation pipe 6. Only due to the different length L1, L2 and L3 of the opening channels 15, 19, 20 of the nozzle elements 11 to 13 the outer dimensions with respect to the length of the chuck cone differ.

The nozzle element openings 16, 21, 22 of the evaporation pipe 6 may be distributed over the surface of the evaporation pipe 6 in any suitable manner. However, it is advantageous for inline coating with a substrate being passed along the evaporation source to arrange the nozzle element openings 16, 21 and 22 in one line or column in order to define a line source. However, other types of arrays of nozzle element openings with corresponding nozzle elements arranged inside are considerable.

Due to the separate production of the nozzle elements 11 to 13 the opening channels 15, 19 and 20 can be formed in a very defined and exact way. Especially, the formation of capillary tubes is suitable for producing very thin nozzle openings.

In order to generate a very homogeneous deposition of the material to be deposited, different nozzle elements which vary with respect to the form and dimensions of the opening channels may be used. However, each opening channel can be exactly designed and produced. Especially, constant diameters of the nozzle opening along the length of the opening channel may be achieved. Moreover, the exact form of the nozzle opening can be realized.

Since the nozzle elements 11 to 13 are just inserted or plugged into the nozzle element openings 16, 21, 22 of the evaporation pipe, the nozzle elements 11 to 13 can be easily exchanged, so that for different evaporation processes different nozzle elements 11 to 13 can be used. Accordingly, for each material adapted nozzle arrangements are possible and therefore the homogeneity of the deposited films is excellent. Moreover, if a nozzle is disturbed by depositions in the opening channel or other problems, the relevant nozzle element can be easily exchanged so that not the complete evaporation pipe 6 has to be replaced.

Figure 3 shows a cross section through the evaporation pipe 6 defining the evaporation pipe volume 18. In order to safely fix the nozzle element 11, a fastening element 17 in form of a ring-shaped metallic clip may be used. The ring-shaped metallic clip 17 which is interrupted in the area of the nozzle element 11 encloses the evaporation pipe 6 and holds by elastic force the nozzle element 11 in position. However, other types of holding or fastening elements may be used.

Although the present invention has been explained in detail with respect to an embodiment shown in the figures, it is evident for a man skilled in the art that the present invention is not restricted to such an embodiment, but comprises alterations and modifications within the scope of the attached claims. Especially some features described with respect to the embodiment may be omitted or the described features may be used in different combinations. Accordingly, the present invention claims all combinations of the presented single features.

## Claims

1. Evaporation source for deposition of thin layers on substrates, the evaporation source comprising a vapor distribution system having an evaporation pipe (6) made of inorganic non metallic material, with the evaporation pipe having at least one nozzle,
**wherein**
the nozzle is disposed in a nozzle element (11, 12, 13) which is made as a separate component being arranged in a nozzle element opening (16, 21, 22) of the evaporation pipe.

2. Evaporation source according to claim 1,
**wherein**
the nozzle element is exchangeably arranged in the nozzle element opening.

3. Evaporation source according to claim 1 or 2,
**wherein**
the nozzle element and/or the evaporation pipe are made of quartz glass.

4. Evaporation source according to any of the previous claims,
**wherein**
the nozzle element opening and/or the nozzle element comprise a chuck cone.

5. Evaporation source according to any of the previous claims,
**wherein**
the nozzle element is plugged into the nozzle element opening.

6. Evaporation source according to claim 5,
**wherein**
the nozzle element is plugged into the nozzle element opening from the outside.

7. Evaporation source according to any of the previous claims,
**wherein**
the nozzle element is clamped into the nozzle element opening by clamping means or a fixation ring.

8. Evaporation source according to any of the previous claims,
**wherein**
the nozzle element has a length which is greater than the depth of the nozzle element opening.

9. Evaporation source according to any of the previous claims,
**wherein**
the nozzle element comprises an opening channel with a defined cross section being essentially constant over the length of the opening channel.

10. Evaporation source according to any of the previous claims,
**wherein**
the nozzle element comprises a capillary tube or a mechanically drilled hole

11. Evaporation source according to any of the previous claims,
**wherein**
a plurality of identical nozzle element openings are provided in the evaporation pipe.

12. Evaporation source according to any of the previous claims,
**wherein**
a plurality of nozzle elements are provided for, the nozzle elements having the same outer dimensions at least with respect to the cross sections in the region towards the nozzle outlet and different opening channels.

13. Evaporation source according to any of the previous claims,
**wherein**
a plurality of nozzle elements are provided for, the nozzle elements having opening channels which are different with respect to at least one of the length and the diameter.

14. Evaporation source according to any of the previous claims,
**wherein**
the nozzle element openings are arranged in at least one column and/or at least one row.

15. Method of producing an Organic Light Emitting Diode (OLED) stack comprising depositing of at least one thin layer by thermal evaporation using an evaporation source according to one of the previous claims.
